# EUROPEAN PATENT SPECIFICATION

(11) **EP 4 050 869 B1**
(45) Date of publication and mention of the grant of the patent: **24.12.2025**
(21) Application number: 20880557.2
(22) Date of filing: 02.06.2020
(51) Int. Cl.: H04M 1/02, B29C 45/26, B29C 43/02, B29C 51/08, B29C 43/52, B29L 31/34, B29L 31/00

(54) **ELECTRONIC DEVICE HOUSING AND MANUFACTURING METHOD THEREFOR, AND ELECTRONIC DEVICE**
GEHÄUSE EINER ELEKTRONISCHEN VORRICHTUNG UND HERSTELLUNGSVERFAHREN DAFÜR SOWIE ELEKTRONISCHE VORRICHTUNG
BOÎTIER DE DISPOSITIF ÉLECTRONIQUE ET SON PROCÉDÉ DE FABRICATION ET DISPOSITIF ÉLECTRONIQUE

(30) Priority: 01.11.2019 CN 201921879692 U; 01.11.2019 CN 201911060936; 01.11.2019 CN 201911061044
(43) Date of publication of application: 31.08.2022
(73) Proprietor: GUANGDONG OPPO MOBILE TELECOMMUNICATIONS CORP., LTD., Dongguan, Guangdong 523860 (CN)
(72) Inventor: LI, Cong, Dongguan, Guangdong 523860 (CN); WANG, Xiaoan, Dongguan, Guangdong 523860 (CN)
(74) Representative: Manitz Finsterwald Patent- und Rechtsanwaltspartnerschaft mbB
(86) International application number: PCT/CN2020/093964
(87) International publication number: WO 2021/082443

(56) References cited:
- WO-A1-2014/117330
- CN-A- 107 197 063
- CN-A- 107 750 103
- CN-A- 107 835 276
- CN-A- 107 867 793
- CN-A- 107 867 793
- CN-A- 110 769 100
- CN-A- 110 856 384
- CN-U- 206 149 655
- CN-U- 210 297 785
- US-A1- 2014 356 563
- US-A1- 2015 077 910

## Description

### TECHNICAL FIELD

The present disclosure relates to the field of electronic devices, and in particular to an electronic device housing, a method for manufacturing the electronic device housing, and an electronic device.

### BACKGROUND

With the development of society and science, people have increased aesthetic requirements for appearances of intelligent terminals. In the art, 2.5D housings and 3D housings are popular. The appearance is mainly about changes in housing colors, such as gradient colors. However, with further development of technology, the housing appearance in the art cannot meet the aesthetic requirements of users, housings with better appearances, stronger visual impacts and more fashionable personalities are desired to meet the aesthetic requirements of users.

The CN patent application No. CN107867793A teaches a preparation method of a curved glass cover plate. The method comprises the steps as follows: textures are produced on a curved hot-bending mold and a textured hot-bending mold is obtained; a planar glass substrate is provided; the planar glass substrate is subjected to hot-bending molding by use of the textured hot-bending mold, so that the planar glass substrate is bent to a curved glass substrate in the required curved shape, textures on the textured hot-bending mold are transferred to one side of the curved glass substrate, and the curved glass cover plate is obtained. According to the preparation method, a textured mold and a hot-bending mold are combined, the cover plate substrate is subjected to hot-bending molding by use of the textured hot-bending mold, the textures are transferred to the cover plate from the hot-bending mold, the method is applicable to texture production of curved substrates in various forms, design and production of single textured molds are not needed, products can be produced quickly, and the development cycle of products is greatly shortened.

The CN patent application No. CN107835276A teaches an electronic equipment flexible cover plate comprising a substrate; the substrate comprises a first surface and a second surface arranged in opposite; the second surface is provided with the first texture; the first surface is provided with a modification layer; the modification layer surface is provided with the second texture; the electronic equipment flexible cover plate is rich in textures, and various in appearances, thus improving user experiences, and satisfying user customized demands. The invention also provides an electronic equipment flexible cover plate manufacturing method comprising the following steps: preparing the substrate, wherein the substrate comprises the first and second surfaces arranged in opposite; using etching or hot press moulding process to form the first texture on the second surface of the substrate; forming the modification layer with the second texture on the first surface of the substrate. The preparation method is simple and easy to operate; the invention also provides the electronic equipment comprising the flexible cover plate.

The US patent application No. US2015/077910A1 teaches a method of manufacturing a housing and an electronic device. The method comprises the following steps: preparing a mold according to a predetermined shape of the housing, wherein the mold comprises at least one moving die and at least one fixed die, a first texture structure is formed on the inner surface of the mold, and the first texture structure comprises a plurality of projections arranged in a first arrangement, and a groove recesses inwardly is formed between any two adjacent projections, and the groove is formed by etching and removing a part of the moving die and/or the fixed die by the laser engraving method; closing the moving die and the fixed die, and heating the mold to a predetermined mold temperature; and injecting a raw material in a melting state into the mold cavity of the mold; retaining a pressure of the raw material in the mold cavity of the mold; cooling the mold; opening the mold to complete the housing. The housing made of the first material exhibits a second material effect in visual and/or tactile senses.

The CN patent application No. CN107197063A teaches a mobile phone cover plate. The mobile phone cover plate comprises a mobile phone cover plate body; the mobile phone cover plate comprises a first surface and a second surface opposite to each other, wherein the first surface is towards the external of the mobile phone, and the second surface is towards the internal of the mobile phone; the 3D textures are formed on the first surface, and the first surface is uneven. The 3D textures are formed on the surface of the mobile phone cover plate, so that the mobile phone cover plate has the uneven hand feeling; the antiskid effect and anti-fingerprint effect are better than the plane glass with even wall thickness; the anti-buffing capacity in the normal use process is stronger, thereby improving the user experience. The invention further provides a preparation method of the mobile phone cover plate and a mobile terminal containing the mobile phone cover plate.

### SUMMARY OF THE DISCLOSURE

The present disclosure aims to solve, at least to some extent, one of the technical problems in the art. The present disclosure provides an electronic device housing, which has a stereoscopic sense and provides a strong visual impact.

According to an aspect, an electronic device housing, a method for manufacturing an electronic device housing, and an electronic device are provided as set out in the appended set of claims.

### BRIEF DESCRIPTION OF THE DRAWINGS

FIG 1 is a structural schematic view of an electronic device housing according to an embodiment of the present disclosure.
FIG 2 is a structural schematic view of an electronic device housing according to another embodiment of the present disclosure.
FIG 3 is a structural schematic view of an electronic device housing according to another embodiment of the present disclosure.
FIG 4 is a structural schematic view of an electronic device housing according to another embodiment of the present disclosure.
FIG 5 is a structural schematic view of an electronic device housing according to another embodiment of the present disclosure.
FIG 6 is a structural schematic view of an electronic device housing according to another embodiment of the present disclosure.
FIG 7 is an enlarged view of a portion in a circle shown in FIG 6.
FIG 8 is a structural schematic view of an electronic device housing according to another embodiment of the present disclosure.
FIG 9 is a structural schematic view of an electronic device housing according to an embodiment of the present disclosure.
FIG 10 is a structural schematic view of an electronic device housing according to another embodiment of the present disclosure.
FIG 11 is a structural schematic view of an electronic device housing according to another embodiment of the present disclosure.
FIG 12 is a structural schematic view of an electronic device housing according to another embodiment of the present disclosure.
FIG 13 is a structural schematic view of an electronic device housing according to another embodiment of the present disclosure.
FIG 14 is a structural schematic view of an electronic device housing according to another embodiment of the present disclosure.
FIG 15 is a structural schematic view of an electronic device housing according to another embodiment of the present disclosure.
FIG 16 is a structural schematic view of an electronic device housing according to another embodiment of the present disclosure.
FIG 17 is a flow chart of manufacturing an electronic device housing according to an embodiment of the present disclosure.
FIG 18 is a structural schematic view of an electronic device housing and a mold after a hot forging process according to an embodiment of the present disclosure.
FIG 19 is a structural schematic view of an electronic device according to an embodiment of the present disclosure.
FIG 20 is a structural schematic view of an electronic device housing according to an embodiment of the present disclosure, wherein an upper portion of the figure is a planar view of an outer surface of a housing body, and a lower portion of the figure is a cross sectional view of the housing body.

### DETAILED DESCRIPTION

Embodiments of the present disclosure will be described in detail below. The embodiments described below are exemplary and are intended to explain the present disclosure only, but shall not be interpreted as limiting the present disclosure. For any part of the embodiments that are not indicated with specific techniques or conditions, the techniques or conditions described in literatures in the art or in product specifications may be followed. Any reagent or instrument whose manufacturers are not specified may be conventional product that can be obtained commercially.

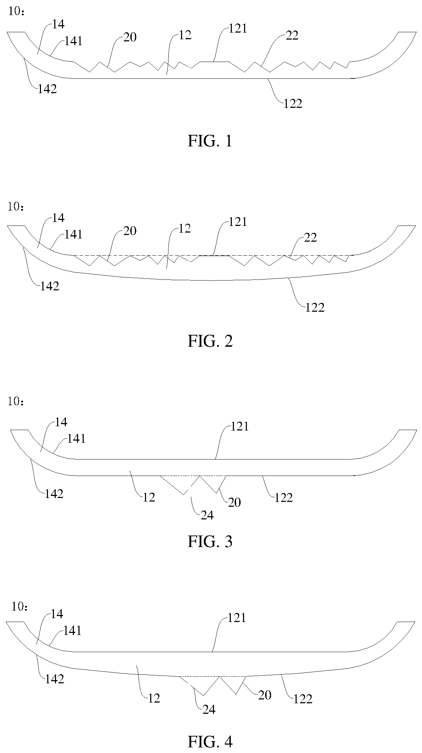

According to an aspect of the present disclosure, an electronic device housing is provided. According to embodiments of the present disclosure, as shown in FIGS. 1 to 6, the electronic device housing includes a housing body 10. The housing body 10 includes a bottom wall 12 and at least one side wall 14 connected to the bottom wall 12. An outer surface 122 of the bottom wall 12 may be flat or curved. An outer surface of the side wall 14 may be curved. At least a portion of at least one of a surface of the bottom wall 12 and a surface of the side wall 14 has a millimeter scale three-dimensional texture 20. In other words, in some embodiments, at least a portion of the surface of the bottom wall 12 has the millimeter scale three-dimensional texture 20; in some embodiments, at least a portion of the surface of the side wall 14 has the millimeter scale three-dimensional texture 20; and in some embodiments, at least a portion of the surface of the bottom wall 12 and at least a portion of the surface of the side wall 14 have the millimeter scale three-dimensional texture 20. For the electronic device housing, the millimeter scale three-dimensional texture is disposed on the surface. A user may intuitively receive a strong stereoscopic visual effect. When the user is holding the electronic device, the user may feel the three-dimensional texture. The housing may simultaneously provide the user the strong stereoscopic three-dimensional effect through visuality and tactility, and may have a good anti-slip performance. The housing meets the requirements of fashion and personalization, and the user may have better usage experience.

To be noted that, in the present disclosure, the term "millimeter scale three-dimensional texture" indicates that a size in at least one of the three dimensions of the texture is millimeter scale, i.e., the size in the at least one of the three dimensions may be 0.1 mm to 10 mm. For example, a height of the texture or a line width of the texture may be millimeter scale. Alternatively, the height of the texture and the line width of the texture may both be millimeter scale.

It shall be understood that, a material of the housing body is not limited by the present disclosure, as long as the material can be applied to the electronic device housing. In detail, the material of the housing body may be glass, ceramic, and so on. In this way, the material may be available from a wide range of sources, a price may be reduced, and a signal shielding problem may be avoided, supporting application of 5G In some embodiments, the material of the housing body may be glass. In this way, the material may be available from a wide range of sources, the housing may have good optical performance and have a low cost.

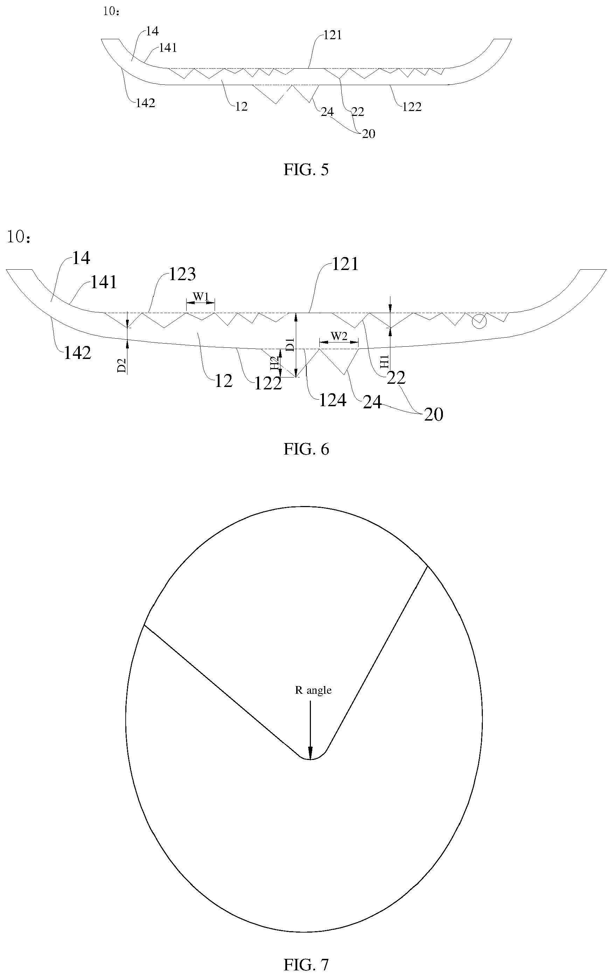

In detail, the millimeter scale three-dimensional texture may include a first three-dimensional texture and a second three-dimensional texture. In some embodiments, as shown in FIGS. 1 and 2, at least one of an inner surface 121 of the bottom wall 12 and an inner surface 141 of the side wall 14 is arranged with the first three-dimensional texture 22. In other embodiments, as shown in FIGS. 3 and 4, at least one of the outer surface 122 of the bottom wall 12 and the outer surface 142 of the side wall 14 is arranged with the second three-dimensional texture 24. In some embodiments, as shown in FIGS. 5 and 6, at least one of the inner surface 121 of the bottom wall 12 and the inner surface 141 of the side wall 14 is arranged with the first three-dimensional texture 22, and at least one of the outer surface 122 of the bottom wall 12 and the outer surface 142 of the side wall 14 is arranged with the second three-dimensional texture 24. In this way, positions at which the three-dimensional texture is arranged may be determined at will. The three-dimensional texture may be arranged on the inner surface only, or on the outer surface only, or both on the inner surface and the outer surface. Various appearances may be achieved by arranging the texture at various positions. It shall be understood that, the inner surface refers to a surface of the shell that faces an inner side of electronic device when the electronic device shell is arranged onto the electronic device, and the outer surface refers to a surface of the shell that faces an outer side of electronic device (i.e., exposed and can be seen by a user) when the electronic device shell is arranged onto the electronic device.

In the present disclosure, it shall be understood that the terms "first" and "second" are used for descriptive purposes only and shall not be interpreted as indicating or implying relative importance or implicitly specifying the number of technical features indicated. Therefore, features defined by the "first" and "second" may expressly or implicitly include one or more of such features.

It shall be understood that, each of the first three-dimensional texture and the second three-dimensional texture described above includes a plurality of textured surfaces, and the plurality of textured surfaces of the first three-dimensional texture is independent from the plurality of textured surfaces of the second three-dimensional texture. At least some of the plurality of textured surfaces intersect with each other. A first R angle is an angle of an intersection of two of the plurality of textured surfaces and has a radius greater than or equal to 0.2 mm. Specifically, the radius of the R angle may be in a range of 0.5 mm to 3 mm, in a range of 0.2 to 1 mm, or in a range of 0.8 to 1 mm. More specifically, the radius of the R angle may be 0.2 mm, 0.3 mm, 0.4 mm, 0.5 mm, 0.6 mm, 0.7 mm, 0.8 mm, 0.9 mm, 1.0 mm, 1.1 mm, 1.2 mm, 1.3 mm, 0.5 mm, 1.8 mm, 2.0 mm, 2.2 mm, 2.5 mm, 2.8 mm, 3.0 mm, and so on. As a result, each of the first three-dimensional texture and the second three-dimensional texture has an obvious angular structure, thereby providing a more stereoscopic appearance, a stronger visual impact, a better hand-holding feeling and anti-slip performance. The housing may be more fashionable and personalized, bringing the user a better experience.

To be noted that, in the present disclosure, the "R angle" refers to an angle of a transition arc at the intersection of two faces in two different directions, and the R angle has a radius. For example, the first R angle refers to an angle of a transition arc at the intersection of two of the plurality of textured surfaces, as shown in FIG 7. In addition, the term "independent" indicates that the plurality of textured surfaces of the first three-dimensional texture do not affect the plurality of textured surfaces of the second three-dimensional texture. For example, each of the plurality of textured surfaces of the first three-dimensional texture and the plurality of textured surfaces of the second three-dimensional texture may individually meet a certain parameter range, indicating that parameter values of the first three-dimensional texture do not affect parameter values of the second three-dimensional texture. That is, the parameter values of the first three-dimensional texture may be equal to or different from the parameter values of the second three-dimensional texture.

It shall be understood that, as shown in FIGS. 5, 6 and 8, the first three-dimensional texture 22 and the second three-dimensional texture 24 may protrude towards an outer side of the housing body 10 or may be recessed towards an inner side of the housing body 10. Protrusion or recess may be determined based on a desired appearance to be achieved. In some embodiments, as shown in FIGS. 5 and 6, the first three-dimensional texture 22 is recessed towards the inner side of the housing body 10, and the second three-dimensional texture 24 protrudes towards the outer side of the housing body 10. In this way, it may be easier to assemble other components of the electronic device with the inner surface of the housing body, which improves space utilization and facilitates miniaturization of electronic device. At the same time, damage to the three-dimensional texture, such as crashes and scratching, during an assembling process may be avoided, such that a higher yield may be achieved, and the housing may have a better appearance. The second three-dimensional texture on the outer surface protrudes towards the outer side of the device. Therefore, the user may directly feel the stereoscopic structure when holding the housing. The housing provides a strong stereoscopic effect both visually and tactilely, providing the user a fresher and more impactful experience, meeting requirements of fashion and personalization.

It shall be understood that, when the three-dimensional texture is not formed, the inner surface and the outer surface of the housing body are flat or curved, and at this moment, the surface of the housing body may be defined as a reference surface. Each of a bottom of the first three-dimensional texture and a bottom of the second three-dimensional texture intersects with the reference surface of the housing body. In some embodiments, as shown in FIG 6, a second R angle is an angle of an intersection of the first three-dimensional texture 22 and the reference surface 123 of the inner surface of the housing body and has a radius greater than or equal to 0.5 mm (in detail, such as 0.5 mm, 0.6 mm, 0.7 mm, 0.8 mm, 0.9 mm, 1.0 mm, and so on). In this way, transition from the inner surface of the housing body to the first three-dimensional texture may be smooth and will not affect subsequent attachment of a device film layer onto the inner surface of the housing body. It shall be understood that the larger the radius of the second R angle is, the smaller the effect on the film attachment. At the same time, the second R angle is located on the inner surface, having a limited effect on the stereoscopic feeling of the housing. Therefore, the second R angle may be made as large as possible according to an actual situation. In some embodiments, as shown in FIG 6, a third R angle is an angle of an intersection of the second three-dimensional texture 24 and the outer surface of the reference surface 124 of the housing body and has a radius greater than or equal to 0.5 mm. The radius of the third R angle may be in a range of 0.8 to 1 mm, such as 0.5 mm, 0.6 mm, 0.7 mm, 0.8 mm, 0.9 mm, 1.0 mm, and so on. In detail, the smaller the radius of the third R angle, the sharper the transition between the second three-dimensional texture and the reference surface at the outer surface of the housing body, and the stronger the stereoscopic effect that the housing has. Therefore, the radius of the third R angle may be made as small as possible based on an actual situation to show a stronger stereoscopic effect.

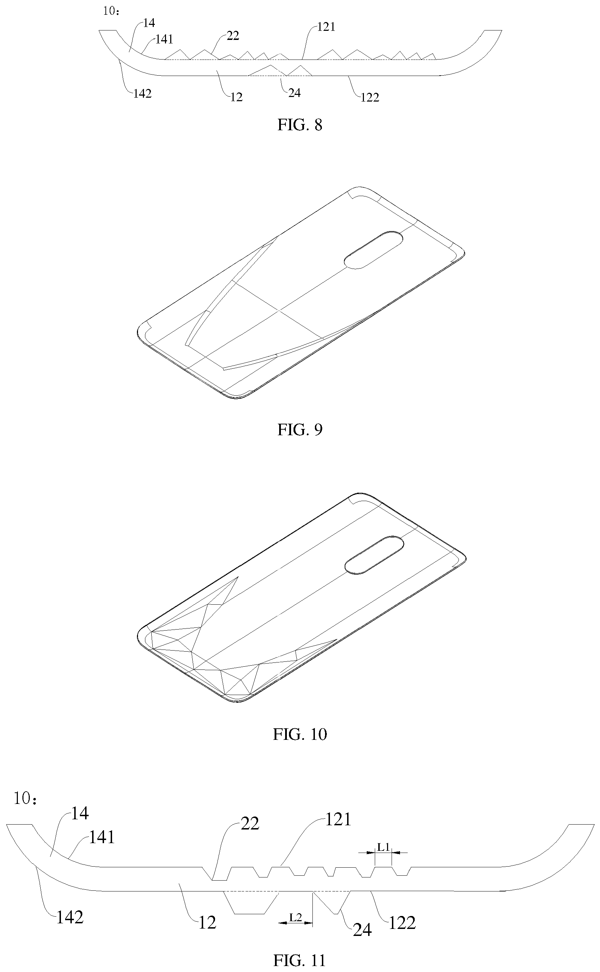

In detail, specific shapes and sizes of the first three-dimensional texture and the second three-dimensional texture are not particularly limited, and can be flexibly determined based on actual demands. In some embodiments, as shown in FIGS. 9 and 10, each of the first three-dimensional texture and the second three-dimensional texture independently includes at least one of linear stripes, curved stripes, geometric shapes and irregular shapes. In this way, more beautiful and a variety of appearance effects can be achieved, and the user experience can be improved.

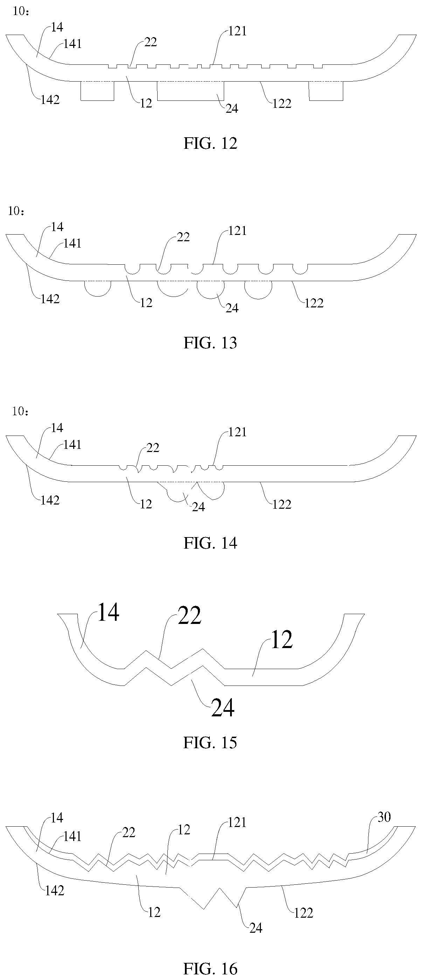

In detail, cross-sectional shapes of the stripes of the first three-dimensional texture and the second three-dimensional texture may be various. In some embodiments, cross-sectional shapes of each stripe of the first three-dimensional texture and each stripe of the second three-dimensional texture may independently be triangular (as shown in FIGS. 5, 6 and 8), trapezoidal (as shown in FIG 11), rectangular (as shown in FIG 12), cut circular (as shown in FIG 13), and other planar geometric and irregular shapes (as shown in FIG 14). In this way, the housing may have a more variety of stereoscopic appearances. To be noted that, the cut circular shape is one of two parts formed by a circle being cut by a straight line. That is, a circle is cut by a straight line to form two parts, each of the two parts may be cut circular.

In detail, a size of the first three-dimensional texture and a size of the second three-dimensional texture of the electronic device housing is millimeter scale (0.1mm to 10mm). The texture in the size in the above range allows the user to intuitively have a strong stereoscopic feeling by naked eyes, and its difference with wavelength of visible light is relatively obvious, and therefore, interference, diffraction and other optical effects may not be generated. In this way, the user may directly feel a strong stereoscopic visual impact. In detail, the height of the first three-dimensional texture is less than or equal to the height of the second three-dimensional texture. In detail, the first three-dimensional texture arranged on the inner surface allows the user to observe the stereoscopic effect by naked eyes. The texture, which has relatively small height, may be effectively identified by the naked eyes, and may be processed easily, allowing other components (such as a decorative film) of the electronic device to be assembled. At the same time, the texture allows the housing body to have a reduced thickness, enabling the housing to be thinner. The second three-dimensional texture located on the outer surface provides the user a stereoscopic visual impact. When the user is holding the electronic device, the user may directly feel the stereoscopic appearance and an anti-slip and anti-hand-falling effect. In order to ensure a more obvious stereoscopic tactility, the height of the second three-dimensional texture may be relatively large.

In some embodiments, the height H1 of the first three-dimensional texture may be in a range of 0.1 mm to 0.25 mm, more specifically in a range of 0.1 mm to 1 mm (such as 0.1 mm, 0.2 mm, 0.3 mm, 0.4 mm, 0.5 mm, 0.6 mm, 0.7 mm, 0.8 mm, 0.9 mm, 1.0 mm, and so on). The height H2 of the second three-dimensional texture is in a range of 0.1 mm to 2.5 mm, more specifically in a range of 0.5 mm to 2 mm, such as 0.5 mm, 0.6 mm, 0.7 mm, 0.8 mm, 0.9 mm, 1.0 mm, 1.1 mm, 1.2 mm, 1.3 mm, 1.4 mm, 1.5 mm, 1.6 mm, 1.7 mm, 1.8 mm, 1.9 mm, 2.0 mm, and so on.

To be noted that, the description "the height of the three-dimensional texture" used in the present disclosure refers to a depth of the three-dimensional texture being recessed toward the inner side of the housing body or a height of the three-dimensional texture protruding toward the outer side of the housing body. In detail, the inner surface of the bottom wall being arranged with the three-dimensional texture may be taken as an example. When the three-dimensional texture is recessed toward the inner side of the housing body, any portion of the three-dimensional texture other than the recessed three-dimensional texture serves as a protruding portion. An inner surface of the protruding portion is located on a flat surface or a curved surface (i.e., the reference surface, indicated by the dashed part shown in FIGS. 5, 6 and 8). The height of the three-dimensional texture refers to the depth of the three-dimensional texture toward the inner side of the housing body relative to the above-mentioned reference surface. Similarly, when the three-dimensional texture protrudes toward the outer side of the housing body, any portion of the three-dimensional texture other than the protruding three-dimensional texture serves as a recessed portion. The recessed portion is located within the above-mentioned reference surface. The height of the three-dimensional texture refers to the height of the three-dimensional texture protruding toward the outer side of the housing body relative to the above-mentioned reference surface.

In some embodiments, each of the line width W1 of the first three-dimensional texture and the line width W2 of the second three-dimensional texture may independently be greater than or equal to 0.5 mm. Specifically, the line width may be greater than or equal to 1 mm. More specifically, the line width may be in a range of 1 mm to 10 mm or in a range of 1mm to 2 mm, such as 1 mm, 1.2 mm, 1.5 mm, 1.8 mm, 2 mm, 3 mm, 4 mm, 5 mm, 6 mm, 7 mm, 8 mm, 9 mm, 10 mm, and the like. To be noted that each of the first three-dimensional texture and the second three-dimensional texture may independently include a plurality of texture lines. The line width of each of the plurality of textures may be within the above range, but may be the same as or different from each other. In the above range, the textures may provide a stronger stereoscopic effect, the appearance of the housing may be better, and the housing may be easily processed. If the line width is excessively small, it may be difficult to process the housing, and the texture may be chipped and damaged. If the line width is excessively large, a more diverse appearance may not be achieved easily.

It shall be understood that, each of the first three-dimensional texture and the second three-dimensional texture may independently be a consecutive texture (as shown in FIG 10) or may be a plurality of textures spaced apart from each other (as shown in FIG 11). In some embodiments, the first three-dimensional texture includes a plurality of first sub-textures spaced apart from each other. A distance L1 between two adjacent first sub-textures may be greater than or equal to 0.5 mm, specifically greater than or equal to 1 mm, or in a range of 1mm to 15 mm, and more specifically may be 1 mm, 2 mm, 3 mm, 4 mm, 5 mm, 6 mm, 7 mm, 8 mm, 9 mm, 10 mm, 11 mm, 12 mm, 13 mm, 14 mm, 15 mm, and so on. In some embodiments, the second three-dimensional texture includes a plurality of second sub-textures spaced apart from each other. A distance L2 between two adjacent second sub-textures may be greater than or equal to 0.5 mm, specifically greater than or equal to 1 mm or in a range of 1 to 15 mm, more specifically may be 1 mm, 2 mm, 3 mm, 4 mm, 5 mm, 6 mm, 7 mm, 8 mm, 9 mm, 10 mm, 11 mm, 12 mm, 13 mm, 14 mm, 15 mm, and so on. In this way, the distance between the textures may be determined flexibly to achieve a wide variety of appearances. At the same time, a larger distance allows a subsequent processing of the housing body to be performed easily, such as applying a decorative film layer to the surface of the housing body.

Further, the line width of the three-dimensional texture and the distance between two adjacent sub-textures may be determined in conjunction to facilitate film application to the housing body. In detail, the distance between two adjacent sub-textures may be small when the line width of the three-dimensional texture is large. The distance between two adjacent sub-textures may be large when the line width of the three-dimensional texture is small. In this way, the subsequent film attachment may be performed easily. In some embodiments, a ratio of the line width W1 of the first sub-texture to the distance L1 between two adjacent first sub-textures is less than or equal to 1:1, specifically may be in a range of 1:1 to 1:8, and more specifically may be in a range of 1:1 to 1:5, such as 1:1, 1:2, 1:3, 1:4, 1:5, 1:6, 1:7, 1:8, 1:9, 1:10, and so on. In some embodiments, a ratio of the line width W2 of the second sub-texture to the distance L2 between two adjacent second sub-textures is less than or equal to 1:1, specifically may be in a range of 1:1 to 1:8, more specifically may be in range of 1:1 to 1:5, such as 1:1, 1:2, 1:3, 1:4, 1:5, 1:6, 1:7, 1:8, 1:9, 1:10, and so on. In the above ratio range, the subsequent film attachment may be performed easily to enable the films to be attached to the housing body more properly, bonding there-between may be stronger, thereby achieving a more diverse and beautiful appearance.

In some embodiments, as shown in FIG 6, a maximum thickness D1 of the housing body 10 may be in a range of 3 mm to 10 mm (specifically, may be 3 mm, 4 mm, 5 mm, 6 mm, 7 mm, 8 mm, 9 mm, 10 mm, and so on). A minimum thickness D2 of the housing body 10 may be greater than or equal to 0.4 mm (specifically, may be 0.4 mm, 0.5 mm, 0.6 mm, 0.7 mm, 0.8 mm, 0.9 mm, 1 mm, 2 mm, 3 mm, 4 mm, 5 mm, 6 mm, 7 mm, 8 mm, 9 mm, and so on). In this way, the three-dimensional texture may be achieved, and at the same time, a strength requirement for the electronic device housing being in use may be met, and the electronic device housing may be thin and light.

To be noted that, the housing body may have different thicknesses at various locations (i.e., of uneven thickness). The maximum thickness of the housing body mentioned above refers to a thickness of a thickest location of the housing body, and the minimum thickness of the housing body mentioned above refers to a thickness of a thinnest location of the housing body. In some embodiments, the housing body may have substantially same thicknesses at various locations (i.e., of uniform thickness), as shown in FIG 15. That is, protrusions and recesses of the first three-dimensional texture on the inner surface of the housing body and the second three-dimensional texture on the outer surface of the housing body cooperate with each other. The first three-dimensional texture 22 on the inner surface protrudes toward the outer side of the housing body, and the second three-dimensional texture 24, which is arranged on the outer surface at a location corresponding to the first three-dimensional texture 22, is recessed toward the inner side of the housing body. Conversely, if the first three-dimensional texture 22 on the inner surface is recessed toward the inner side of the housing body, then the second three-dimensional texture 24, which is arranged on the outer surface at a location corresponding to the first three-dimensional texture 22, protrudes towards the outer side of the housing body. In this way, a manufacturing cost of the housing body may be lower.

To be noted that, ideally, thicknesses of the housing body at the various locations may be identical. However, due to unavoidable accuracy and errors in the processing, it may be difficult to achieve identical thickness in practice. In the present disclosure, the description of "the housing body may have substantially same thicknesses at various locations" indicates that thicknesses at the various locations are exactly the same, or a difference in the thicknesses at various locations is within an allowable range caused by machining accuracy and errors.

In addition, an orthographic projection of the first three-dimensional texture and an orthographic projection of the second three-dimensional texture in a thickness direction of the housing body may be at least partially non-overlapping. In this way, both the first three-dimensional texture and the second three-dimensional texture may be directly seen by the user, and the housing may show a variety of appearances. In some embodiments, the orthographic projection of the first three-dimensional texture and the orthographic projection of the second three-dimensional texture in the thickness direction of the housing body may not overlap at all, or may be partially overlapping and partially non-overlapping. Further, the first three-dimensional texture and the second three-dimensional texture may be superimposed to form a complete decorative pattern. For example, the first three-dimensional texture may be a pattern of a star, and the second first texture may be a pattern of a moon, a sun and other planets. The two textures may be superimposed to form a decorative pattern of sky and the like. In this way, a variety of decorative patterns are achieved, and a strong special stereoscopic effect may be achieved.

It shall be understood that, as shown in FIG 16, the electronic device housing further includes a decorative film 30. The decorative film 30 is arranged on an inner surface of the bottom wall 12 and an inner surface of the side wall 14. In this way, the decorative film achieves a decorative effect on the appearance of the housing body by providing various colors, various patterns and so on, such that the appearance of the housing may be diverse and brilliant, and may meet the aesthetic requirements of the user.

It shall be understood that, the decorative film may be a multi-layer structure. In detail, the decorative film may include a color layer, a texture layer, a bottom ink layer and a necessary bonding layer, and so on. Further, the decorative film may include a substrate film. The above-mentioned color layer, texture layer, bottom ink layer, and so on, may be arranged on the substrate film firstly and attached to the inner surface of the housing subsequently. A specific structure and material of the decorative film may be determined based on the desired appearance of the housing, and will not be described in detail herein.

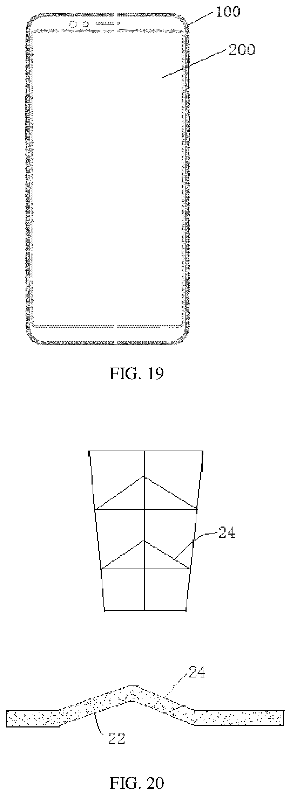

In some embodiments, various slopes with surfaces are arranged. The outer surface of the glass housing body, which is arranged with the second three-dimensional texture, may be disposed on the slope and face the slope. Subsequently, an angle of the slope may be continuously increased until the glass housing body starts to slide down. An angle of the slope at which the glass housing body starts to slide down may be recorded. A test result shows that the angle of the slope at which the housing body arranged with the millimeter scale three-dimensional texture starts to slide down is more than eight times of the angle of the slope at which a flat glass without the three-dimensional texture starts to slide down. In an embodiment, as shown in FIG 20, the thicknesses at various locations of the housing body are substantially the same. The outer surface is arranged with a protruded second three-dimensional texture 24, and the inner surface is arranged with a recessed first three-dimensional texture 22. A minimum second R angle at a long side and corners is 3.9 mm, and a minimum second R angle at a short side is 4.2 mm. The slide-down angle test as mentioned above is performed on a glossy glass. A test result shows that the angle of the slope at which the glass without the three-dimensional texture starts to slide down is 1.97 degrees, and the angle of the slope for the housing body arranged with the three-dimensional texture shown in FIG 20 to start sliding down is 16.8 degrees. Therefore, the three-dimensional texture enhances the visual and tactile stereoscopic effect, and also significantly improves anti-slip performance.

According to another aspect, the present disclosure provides a method of manufacturing the electronic device housing. According to the embodiments, the method includes following operations. A molding process may be performed on the substrate to obtain the housing body. The housing body includes a bottom wall and at least one side wall connected to the bottom wall. An outer surface of the bottom wall is flat or curved, and an outer surface of the side wall is curved. At least part of the surfaces of at least one of the bottom wall and the side wall is arranged with a millimeter scale three-dimensional texture. Operations of the method may be simple and may be performed easily. The method may be performed highly in automation and can achieve a high processing accuracy. The processing technology is mature, and can easily achieve industrial production of the housing. At the same time, the obtained housing can provide the user a strong stereoscopic effect both visually and tactilely, meeting the requirements of fashion and personalization, and enabling the user to have better usage experience.

In some embodiments, the substrate may be glass. The molding process may include following operations. The substrate may be placed in a mold, and a hot forging process may be performed at a predetermined temperature on the substrate to obtain the housing body. The predetermined temperature may be 100 degrees Celsius to 150 degrees Celsius lower than a softening point of the substrate (in detail, such as 100 degrees Celsius, 110 degrees Celsius, 120 degrees Celsius, 130 degrees Celsius, 140 degrees Celsius, 150 degrees Celsius, and so on, lower than the softening point). According to the present method, the surface of the glass substrate may be processed to form a new shape. In detail, the surface may be converted from a flat surface to a stereoscopic three-dimensional structure (i.e., the three-dimensional texture arranged on the surface), allowing the electronic device housing to have a stereoscopic structure and appearance, significantly diversifying the appearance of the electronic device housing and significantly improving the aesthetics and user experience of the electronic device housing.

In detail, the above temperature range may allow a clear three-dimensional texture to be formed, and may significantly reduce a molding mark. If the temperature is excessively low, a clear texture may be not be formed by the hot forging operation and may be fragmented easily, and a size and profiling of computer aided verification (CAV) of the texture may not be controlled properly. If the temperature is excessively high, the molding mark may be severe, increasing the difficulty of a subsequent sweeping process (such as sweeping for a long time causing the texture to be collapsed, sweeping for a short time being unable to remove the molding mark), and at the same time, oxidation of the mold may be accelerated (about 5%-8%). It shall be understood that, the temperature range can be adjusted properly based on the glass material of the substrate and various texture effects in combination of practical experience. Generally, the thicker the glass, the higher the temperature. When the glass material is changed, the temperature may be determined based on a softening point of the glass. In detail, for example, a softening point of the Corning glass is 880 degrees Celsius, and the temperature of its hot forging operation may be 730 degrees Celsius to 780 degrees Celsius. A softening point of the NSG glass is 700 degrees Celsius, and the temperature of its hot forging operation may be 550 degrees Celsius to 600 degrees Celsius. A softening point of the AGC glass is 770 degrees Celsius, and the temperature of its hot forging operation may be 620 degrees Celsius to 670 degrees Celsius.

It shall be understood that, the present disclosure does not specifically limit the glass material, any glass that meets requirements for manufacturing the electronic device housing may be applied. For example, the glass material includes, but is not limited to, high aluminum-silica glass, soda lime glass, lithium-aluminum-silica glass, and so on. Specifically, the glass may be the Corning glass, the AGC glass, and so on. In detail, a thickness of the glass substrate may be 0.5 mm to 1 mm (specifically, such as 0.5 mm, 0.6 mm, 0.7 mm, 0.8 mm, 0.9 mm, 1.0 mm, and so on). In the thickness range, the glass substrate may have better strength, complex and diverse three-dimensional textures may be achieved easily, and the stereoscopic effect may be better. If the thickness is excessively large, a relatively simple three-dimensional texture may be formed, and the stereoscopic effect of the three-dimensional texture may be relatively weak. If the thickness is excessively small, the housing may be fragmented easily, and strength requirements of the housing can hardly be met.

In detail, detailed hot forging operation may refer to placing the glass substrate in a molding cavity of a mold and pressurizing a closed mold at a molding temperature, such that the glass substrate is molded into a target shape (specifically, such as a three-dimensional texture). In detail, the mold for hot forging the glass substrate may include an upper mold and a lower mold. A temperature of the upper mold and a temperature of the lower mold in the hot forging operation may both be within the temperature range described above, and the temperature of the upper mold is greater than the temperature of the lower mold. In this way, the temperature may be suitable, the formed three-dimensional texture may be clear, the molding mark may be slight or even absent, no small and large edges may be formed, and dimensions may be precise. It shall be understood that the specific temperature may be adjusted properly based on the glass material, the structure and the CAV profile of the three-dimensional texture. To be noted that, the temperatures of the upper mold and the lower mold described herein refer to a temperature of a preheating operation and a temperature of a hot forging station in the hot forging operation, and a temperature of a subsequent slow cooling operation is not included.

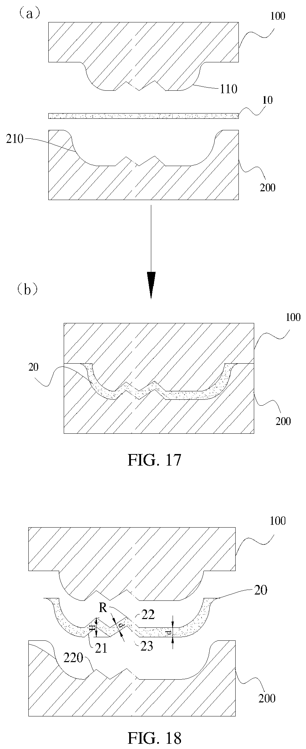

It shall be understood that, as shown in FIG 17, the upper mold 100 may be a convex mold, and a lower mold 200 may be a concave mold. In detail, the lower mold 200 has a recessed portion 210. The glass substrate 10 may be disposed between the upper mold 100 and the lower mold 200. The upper mold 100 is arranged with a protruding portion 110 that matches the recessed portion 210. While performing the hot forging operation, the upper mold 100 and the lower mold 200 are closed, and the glass substrate is shaped under a pressure of the molds to obtain the electronic device housing 20 arranged with the three-dimensional texture. It shall be understood that a shape of the mold matches the shape of the three-dimensional texture. For example, as shown in FIG 18, when the recessed three-dimensional texture 21, which faces the upper mold, is to be arranged on the surface of the glass substrate 10 near the lower mold 200, a surface of the lower mold 200 in contact with the glass substrate 10 needs to have a protrusion 220 that faces the glass substrate 10 and matches the above recessed three-dimensional texture 21.

It shall be understood that, in the hot forging operation, a magnitude of the pressure may have a certain impact on the molding process. In some embodiments, the pressure of the hot forging process may be greater than or equal to 80 Kg and less than or equal to 200 Kg. More specifically, the pressure may be greater than or equal to 80 Kg and less than or equal to 140 Kg, such as 80 Kg, 90 Kg, 100 Kg, 110 Kg, 120 Kg, 130 Kg, 140 Kg, 150 Kg, 160 Kg, 170 Kg, 180 Kg, 190 Kg, 200 Kg, and so on. Within this pressure range, a better stereoscopic effect of the texture may be achieved by the hot forging operation, the molding mark may be slight, and a service life of the mold may be increased. If the pressure is excessively large, the glass may be deformed easily and broken into pieces, the service life of the mold may be reduced, and the molding mark may be severe, such that time spent for performing the subsequent sweeping process may be increased, the sweeping efficiency may be reduced, and costs of the sweeping process may be increased. In a case of a same time duration and a same temperature being applied, if the pressure is excessively small, it may be difficult to form the three-dimensional texture by pressing, fragments may be generated easily, and the mold may be damaged. Of course, it shall be understood that the pressure range may be adjusted properly based on glass materials and the three-dimensional texture structure, in combination with practical experience and other parameters such as time.

In detail, the hot forging and molding process may specifically include three processes: a heating process, a shaping process and a cooling process. Each of the above processes may involve a plurality of working stations. According to the present disclosure, time duration of the entire hot forging and molding process may be greater than or equal to 20 minutes and less than 40 minutes (specifically, such as 20 minutes, 21 minutes, 25 minutes, 28 minutes, 30 minutes, 32 minutes, 35 minutes, 36 minutes, 38 minutes, 39 minutes, and so on). Further, time duration of each of the plurality of working stations in the hot forging and molding process may be 50 seconds to 150 seconds, more specifically may be 65 seconds to 120 seconds, such as 50 seconds, 55 seconds, 60 seconds, 65 seconds, 70 seconds, 75 seconds, 80 seconds, 85 seconds, 90 seconds, 95 seconds, 100 seconds, 105 seconds, 110 seconds, 115 seconds, 120 seconds, 125 seconds, 130 seconds, 135 seconds , 140 seconds, 45 seconds, 150 seconds, and so on. In the above time range, a clear three-dimensional texture may be formed in a short time period, and a high processing efficiency and yield may be achieved. If the time duration is excessively short, the formed three-dimensional texture may not be clear, and the precision may be low. If the time duration is excessively long, the texture may be formed in an excessively long period of time, and the molding mark may be severe, reducing the efficiency and increasing the costs.

In some embodiments, the molding process may include following operations. The substrate is provided, and the substrate has an inner surface and an outer surface opposite to the inner surface. CNC machining may be performed on the substrate. The CNC machining includes following operations. A portion of the substrate is removed from the inner surface, such that a bottom wall and at least one side wall connected to the bottom wall are formed on the substrate. A position of the outer surface of the substrate corresponding to the side wall may be machined to be curved. The millimeter scale three-dimensional texture may be formed on at least a part of the surface of at least one of the bottom wall and the side wall. The method is carried out by performing the CNC machining. Operations may be simple, and may be easily performed. The method may be highly automated, and the processing accuracy may be high. The CNC machining technology is mature, and industrial production may be achieved easily.

It shall be understood that, in the CNC machining process, the present disclosure does not limit an order of performing the operations of removing a part of the substrate from the inner surface, forming the three-dimensional texture, and processing the outer surface. Removing a part of the substrate and forming the three-dimensional texture may be performed firstly, and subsequently, the outer surface may be machined to be curved. Alternatively, the outer surface may be machined to be curved firstly, and subsequently, a part of the substrate may be removed, and the three-dimensional texture may be formed. The order of performing the above operations may be flexibly adjusted based on the needs.

It shall be understood that, the CNC machining may further include following operations. The outer surface of the substrate at a position corresponding to the bottom wall may be machined into a curved surface. In this way, the housing having a 3D structure may be obtained.

In detail, when the three-dimensional texture is arranged on the inner surface of the housing body only, the molding process may include following operations. The substrate may be provided to have an inner surface and an outer surface opposite to the inner surface. CNC machining may be performed on the substrate. The CNC machining includes following operations. A portion of the substrate may be removed from the inner surface, such that a bottom wall and at least one side wall connected to the bottom wall may be formed on the substrate, and the millimeter scale three-dimensional texture may be formed on at least one of the inner surface of the bottom wall and the inner surface of the side wall. The outer surface of the substrate at a position corresponding to the side wall is machined to be curved.

In an embodiment, a flat substrate may be provided firstly. Subsequently, the three-dimensional texture may be formed on the inner surface of the substrate by the CNC machining. Subsequently, the outer surface corresponding to the side wall may be machined to be curved by the CNC machining.

In another embodiment, a flat substrate may be provided firstly. Subsequently, the CNC machining may be performed to obtain the bottom wall and at least one side wall connected to the bottom wall on the substrate and to form a three-dimensional texture on the inner surface of the substrate. Subsequently, the resulting product may be fixed on a jig having a shape copying the three-dimensional texture (specifically, a 3D base of the jig having the profiled texture). Further, the machining process may be performed to machine the outer surface corresponding to the side wall to be curved and to form the three-dimensional texture on the outer surface corresponding to the bottom wall.

In detail, when both the inner surface and the outer surface of the housing body are arranged with the three-dimensional textures, the molding process may include following operations. A substrate may be provided to have the inner surface and the outer surface opposite to the inner surface. A first CNC machining process may be performed on the substrate. The first CNC machining process includes following operations. A portion of the substrate may be removed from the inner surface, such that the bottom wall and at least one side wall connected to the bottom wall are formed on the substrate, and the first three-dimensional texture may be formed on at least one of the inner surface of the bottom wall and the inner surface of the side wall. A second CNC machining process may be performed on the substrate having been treated by the first CNC machining process. The second CNC machining process includes following operations. The outer surface of the substrate at a position corresponding to the side wall may be machined to be curved. A portion of the substrate may be removed from the outer surface, such that the second three-dimensional texture may be formed on at least one of the outer surface of the bottom wall and the outer surface of the side wall. While performing the method, the CNC machining process is performed. Operations may be simple, and may be easily performed. The method may be highly automated, and the processing accuracy may be high. The CNC machining technology is mature, and industrial production may be achieved easily.

It shall be understood that, while performing the second CNC machining process, the present disclosure does not limit an order of the operation of removing the part of the substrate from the outer surface to form the second three-dimensional texture and the operation of processing the outer surface of the substrate at a position corresponding to the side wall to be curved. A part of the substrate may be removed to form the second three-dimensional texture firstly, and subsequently, the outer surface at a position corresponding to the side wall may be machined to be curved. Alternatively, the outer surface at a position corresponding to the side wall may be machined to be curved firstly, and subsequently, a part of the substrate may be removed to form the second three-dimensional texture. The order of the operations may be flexibly adjusted based on the needs.

It shall be understood that the above method may further include following operations: the outer surface of the substrate at a position corresponding to the bottom wall is machined to be curved. In this way, the housing with a 3D structure may be obtained. In detail, the present operation may be performed before or simultaneously with the operation of forming the second three-dimensional texture.

In detail, before the second CNC machining process, the substrate having been treated by the first CNC machining process is fixed to a jig. A surface of the jig contacting the substrate is arranged with a profiled three-dimensional texture complementary to the first three-dimensional texture, such that the first three-dimensional texture may be fixed with and fit into the profiled three-dimensional texture. Therefore, the substrate arranged with the first three-dimensional texture may be better fixed, and the profiled three-dimensional texture may fit well with the first three-dimensional texture without damaging the first three-dimensional texture.

To be noted that, the expression of "a profiled three-dimensional texture complementary to the first three-dimensional texture" in the present disclosure shall be interpreted as the profiled three-dimensional texture being complementary to the first three-dimensional texture, specifically indicating that sizes of the first three-dimensional texture and the profiled three-dimensional texture and tendencies of protruding and recessing at corresponding positions (i.e., for the substrate being fixed to the jig, positions of the jig and the substrate that need to contact each other) may be substantially the same. When the substrate is fixed to the jig, the three-dimensional texture may be placed exactly in the profiled three-dimensional texture, and almost no gap is defined there-between at the positions where the jig and the substrate contact each other.

In detail, detailed operations and parameters of the CNC machining process may be flexibly adjusted based on a structure and a pattern that are desired to be achieved, and will not be described herein. The ordinary skilled person in the art shall understand that the method may be performed to prepare the electronic device housing described in the above. The features and advantages may be referred to the corresponding description in the above, and will not be described here.

In an embodiment, a flat substrate may be provided firstly. Subsequently, the first three-dimensional texture may be formed on the inner surface of the substrate by the CNC machining process. Subsequently, the obtained substrate may be fixed on a jig having the above-mentioned profiled three-dimensional texture (specifically, on a 3D base of the jig having the profiled texture). Further, a further CNC machining process may be performed on the outer surface corresponding to the side wall, such that the outer surface corresponding to the side wall may be curved, and the second three-dimensional texture may be formed on the outer surface corresponding to the bottom wall.

According to another aspect, the present disclosure provides an electronic device. According to an embodiment of the present disclosure, as shown in FIG 19, the electronic device includes the electronic device housing 100 as described in the above and a display 200. The side wall and the bottom wall of the electronic device housing cooperatively defines an accommodating space. The display 200 is received in the accommodating space. The electronic device provides a strong stereoscopic effect and a strong visual impact. The user may grip the electronic device comfortably. The increasingly high aesthetic requirements for appearances of electronic devices may be met, greatly improving the user experience.

It shall be understood that, the specific type of the electronic device is not particularly limited herein, and may be any conventional electronic device, for example, including but not limited to mobile phones, tablet computers, game consoles, wearable devices, life appliances, and so on. In addition, the ordinary skilled person in the art shall understand that, in addition to the above-described electronic device housing, the electronic device may further include other structures and components that are conventionally necessary for electronic devices. For example, for a mobile phone, a touch module, a camera module, a fingerprint recognition module, a sound processing system, a battery, a motherboard, a memory and necessary circuit structures, and so on, may further be included, and will not be described in detail herein.

In the description of the present specification, description made with reference to terms of "an embodiment," "some embodiments," "an example," "specific examples," or "some examples" mean that specific features, structures, materials, or properties described may be included in at least one embodiment or example of the present disclosure. In the present specification, the exemplary representation of the above terms does not indicate one same embodiment or example. Moreover, the specific features, structures, materials, or properties described may be combined in a suitable manner in any one or more embodiments or examples. In addition, without conflicting with each other, any ordinary skilled person in the art may combine and associate various embodiments or examples described in the present specification and the features of the various embodiments or examples.

## Claims

1. An electronic device housing, comprising:
a housing body (10), comprising a first wall (12) and at least one second wall (14) connected to the first wall (12), the first wall (12) having an inner surface (121) and an outer surface (122) opposite to the inner surface (121), the second wall (14) having an inner surface (141) and an outer surface (142) opposite to the inner surface (141) of the second wall (14), the inner surface (121) of the first wall (12) and the inner surface (141) of the at least one second wall (14) cooperatively defining an accommodating space, wherein the outer surface (122) of the first wall (12) is flat or curved, the outer surface (142) of the at least one second wall (14) is curved, and at least part of at least one of the outer surfaces (122, 142) and the inner surfaces (121, 141) of the first wall (12) and the second wall (14) is arranged with a millimeter scale three-dimensional texture (20);
wherein the millimeter scale three-dimensional texture (20) comprises a first three-dimensional texture (22) and a second three-dimensional texture (24),
at least one of the inner surface (121) of the first wall (12) and the inner surface (141) of the second wall (14) is arranged with the first three-dimensional texture (22), and at least one of the outer surface (122) of the first wall (12) and the outer surface (142) of the second wall (14) is arranged with the second three-dimensional texture (24); and
each of the first three-dimensional texture (22) and the second three-dimensional texture (24) comprises a plurality of textured surfaces, the plurality of textured surfaces comprise surfaces extending in different directions;
a first R angle is formed at an intersection of two of the plurality of textured surfaces and has a first radius in a range of 0.2 to 1 mm;
a second angle is formed at an intersection between the first three-dimensional texture (22) and a reference surface of the inner surface of the housing body (10) and has a second radius, and the second radius is greater than or equal to 0.5 mm.

2. The electronic device housing according to claim 1, wherein the first radius is in a range of 0.8 mm to 1 mm.

3. The electronic device housing according to any one of claims 1 to 2, wherein another angle is formed at an intersection between the second three-dimensional texture (24) and a reference surface of the outer surface of the housing body (10) has a third radius, and the third radius is greater than or equal to 0.5 mm, preferably in a range of 0.8 mm to 1 mm.

4. The electronic device housing according to any one of claims 1 to 3, wherein the first three-dimensional texture (22) is recessed towards an inner side of the housing body (10), and the second three-dimensional texture (24) protrudes towards an outer side of the housing body (10).

5. The electronic device housing according to any one of claims 1 to 4, wherein the height of the first three-dimensional texture (22) is less than the height of the second three-dimensional texture (24);
the height of the first three-dimensional texture (22) is in a range of 0.1 mm to 1 mm; and
the height of the second three-dimensional texture (24) is in a range of 0.5 mm to 2.5 mm.

6. The electronic device housing according to any one of claims 1 to 5, wherein a line width of each of the first three-dimensional texture (22) and the second three-dimensional texture (24) is greater than or equal to 0.5 mm, preferably greater than or equal to 1 mm, more preferably in a range of 1 mm to 2 mm.

7. The electronic device housing according to any one of claims 1 to 6, wherein,
the first three-dimensional texture (22) comprises a plurality of first sub-textures spaced apart from each other, a distance between two adjacent first sub-textures being greater than or equal to 0.5 mm, preferably greater than or equal to 1 mm; and
the second three-dimensional texture (24) comprises a plurality of second sub-textures spaced apart from each other, a distance between two adjacent second sub-textures being greater than or equal to 0.5 mm, preferably greater than or equal to 1 mm.

8. The electronic device housing according to any one of claims 1 to 7, wherein
a ratio of a width of the first sub-texture to a distance between two adjacent first sub-textures is less than or equal to 1: 1, preferably in a range of 1:1 to 1:8, more preferably in a range of 1:1 to 1:5; and
a ratio of a width of the second sub-texture to a distance between two adjacent second sub-textures is less than or equal to 1: 1, preferably in a range of 1:1 to 1:8, more preferably in a range of 1:1 to 1:5.

9. The electronic device housing according to any one of claims 1 to 8, wherein each of the first three-dimensional texture (22) and the second three-dimensional texture (24) comprises at least one of linear stripes, curved stripes, geometric patterns and irregular-shaped patterns.

10. The electronic device housing according to any one of claims 1 to 9, wherein an orthographic projection of the first three-dimensional texture (22) in a thickness direction of the housing body (10) is at least partially non-overlapping with an orthographic projection of the second three-dimensional texture (24) in the thickness direction of the housing body (10).

11. The electronic device housing according to any one of claims 1 to 10, wherein a maximum thickness of the housing body (10) is in a range of 3 mm to 10 mm, and a minimum thickness of the housing body (10) is greater than or equal to 0.4 mm.

12. A method for manufacturing an electronic device housing, comprising:
performing a molding process on a substrate to obtain a housing body (10), wherein the housing body (10) comprises a first wall (12) and at least one second wall (14) connected to the first wall (12), wherein the first wall (12) having an inner surface (121) and an outer surface (122) opposite to the inner surface (121), the second wall (14) having an inner surface (141) and an outer surface (142) opposite to the inner surface (141) of the second wall (14), the inner surface (121) of the first wall (12) and the inner surface (141) of the at least one second wall (14) cooperatively defining an accommodating space; and the outer surface (122) of the first wall (12) is flat or curved, the outer surface (142) of the second wall (14) is curved, and at least part of at least one of the outer surfaces and the inner surfaces of the first wall (12) and the second wall (14) is arranged with a millimeter scale three-dimensional texture;
wherein the millimeter scale three-dimensional texture (20) comprises a first three-dimensional texture (22) and a second three-dimensional texture (24);
at least one of the inner surface (121) of the first wall (12) and the inner surface (141) of the second wall (14) is arranged with the first three-dimensional texture (22), and at least one of the outer surface (122) of the first wall (12) and the outer surface (142) of the second wall (14) is arranged with the second three-dimensional texture (24); and
each of the first three-dimensional texture (22) and the second three-dimensional texture (24) comprises a plurality of textured surfaces, the plurality of textured surfaces comprise surfaces extending in different directions;
a first R angle is formed at an intersection of two of the plurality of textured surfaces and has a first radius in a range of 0.2 to 1 mm;
a second angle is formed at an intersection between the first three-dimensional texture (22) and a reference surface of the inner surface of the housing body (10) and has a second radius, and the radius is greater than or equal to 0.5 mm.

13. An electronic device, comprising:
the electronic device housing according to any one of claims 1 to 11; and
a display (200), received in the accommodating space of the electronic device.

## Patentansprüche

1. Gehäuse für ein elektronisches Gerät, Folgendes umfassend:
einen Gehäusehauptteil (10), der eine erste Wand (12) und mindestens eine zweite Wand (14) umfasst, die mit der ersten Wand (12) verbunden ist, wobei die erste Wand (12) eine Innenfläche (121) und eine Außenfläche (122) gegenüber der Innenfläche (121) aufweist, wobei die zweite Wand (14) eine Innenfläche (141) und eine Außenfläche (142) gegenüber der Innenfläche (141) der zweiten Wand (14) aufweist, wobei die Innenfläche (121) der ersten Wand (12) und die Innenfläche (141) der mindestens einen zweiten Wand (14) zusammenwirkend einen Unterbringungsraum definieren, wobei die Außenfläche (122) der ersten Wand (12) eben oder gekrümmt ist, die Außenfläche (142) der mindestens einen zweiten Wand (14) gekrümmt ist und mindestens ein Teil von mindestens einer der Außenflächen (122, 142) und der Innenflächen (121, 141) der ersten Wand (12) und der zweiten Wand (14) mit einer dreidimensionalen Textur (20) im Millimeterbereich angeordnet ist,
wobei die dreidimensionale Textur (20) im Millimeterbereich eine erste dreidimensionale Textur (22) und eine zweite dreidimensionale Textur (24) umfasst,
mindestens eine von der Innenfläche (121) der ersten Wand (12) und der Innenfläche (141) der zweiten Wand (14) mit der ersten dreidimensionalen Textur (22) angeordnet ist und mindestens eine von der Außenfläche (122) der ersten Wand (12) und der Außenfläche (142) der zweiten Wand (14) mit der zweiten dreidimensionalen Textur (24) angeordnet ist, und
die erste dreidimensionale Textur (22) und die zweite dreidimensionale Textur (24) jeweils mehrere texturierte Flächen umfassen, wobei die mehreren texturierten Flächen Flächen umfassen, die sich in unterschiedliche Richtungen erstrecken,
ein erster R-Winkel an einem Schnittpunkt von zwei der mehreren texturierten Flächen gebildet ist und einen ersten Radius in einem Bereich von 0,2 bis 1 mm aufweist,
ein zweiter Winkel an einem Schnittpunkt zwischen der ersten dreidimensionalen Textur (22) und einer Referenzfläche der Innenfläche des Gehäusehauptteils (10) gebildet ist und einen zweiten Radius aufweist und der Radius größer als oder gleich 0,5 mm ist.

2. Gehäuse für ein elektronisches Gerät nach Anspruch 1, wobei der erste Radius in einem Bereich von 0,8 bis 1 mm liegt.

3. Gehäuse für ein elektronisches Gerät nach einem der Ansprüche 1 bis 2, wobei ein weiterer Winkel an einem Schnittpunkt zwischen der zweiten dreidimensionalen Textur (24) und einer Referenzfläche der Außenfläche des Gehäusehauptteils (10) gebildet ist, der einen dritten Radius aufweist, und der dritte Radius größer als oder gleich 0,5 mm ist, vorzugsweise in einem Bereich von 0,8 bis 1 mm liegt.

4. Gehäuse für ein elektronisches Gerät nach einem der Ansprüche 1 bis 3, wobei die erste dreidimensionale Textur (22) hin zu einer Innenseite des Gehäusehauptteils (10) vertieft ist und die zweite dreidimensionale Textur (24) hin zu einer Außenseite des Gehäusehauptteils (10) hervorsteht.

5. Gehäuse für ein elektronisches Gerät nach einem der Ansprüche 1 bis 4, wobei die Höhe der ersten dreidimensionalen Textur (22) geringer als die Höhe der zweiten dreidimensionalen Textur (24) ist,
die Höhe der ersten dreidimensionalen Textur (22) in einem Bereich von 0,1 mm bis 1 mm liegt und
die Höhe der zweiten dreidimensionalen Textur (24) in einem Bereich von 0,5 mm bis 2,5 mm liegt.

6. Gehäuse für ein elektronisches Gerät nach einem der Ansprüche 1 bis 5, wobei eine Linienbreite von jeweils der ersten dreidimensionalen Textur (22) und der zweiten dreidimensionalen Textur (24) größer als oder gleich 0,5 mm ist, vorzugsweise größer als oder gleich 1 mm, oder bevorzugter in einem Bereich von 1 mm bis 2 mmm liegt.

7. Gehäuse für ein elektronisches Gerät nach einem der Ansprüche 1 bis 6, wobei:
die erste dreidimensionale Textur (22) mehrere erste Teiltexturen umfasst, die voneinander beabstandet sind, wobei ein Abstand zwischen zwei benachbarten ersten Teiltexturen größer als oder gleich 0,5 mm ist, vorzugsweise größer als oder gleich 1 mm, und
die zweite dreidimensionale Textur (24) mehrere zweite Teiltexturen umfasst, die voneinander beabstandet sind, wobei ein Abstand zwischen zwei benachbarten zweiten Teiltexturen größer als oder gleich 0,5 mm ist, vorzugsweise größer als oder gleich 1 mm.

8. Gehäuse für ein elektronisches Gerät nach einem der Ansprüche 1 bis 7, wobei:
ein Verhältnis einer Breite der ersten Teiltextur zu einem Abstand zwischen zwei benachbarten ersten Teiltexturen kleiner als oder gleich 1:1 ist, vorzugsweise in einem Bereich von 1:1 bis 1:8 liegt, bevorzugter in einem Bereich von 1:1 bis 1:5, und
ein Verhältnis einer Breite der zweiten Teiltextur zu einem Abstand zwischen zwei benachbarten zweiten Teiltexturen kleiner als oder gleich 1:1 ist, vorzugsweise in einem Bereich von 1:1 bis 1:8 liegt, bevorzugter in einem Bereich von 1:1 bis 1:5.

9. Gehäuse für ein elektronisches Gerät nach einem der Ansprüche 1 bis 8, wobei die erste dreidimensionale Textur (22) und die zweite dreidimensionale Textur (24) mindestens eines von geraden Streifen, gekrümmten Streifen, geometrischen Mustern und unregelmäßigen Mustern umfassen.

10. Gehäuse für ein elektronisches Gerät nach einem der Ansprüche 1 bis 9, wobei eine senkrechte Projektion der ersten dreidimensionalen Textur (22) in einer Dickenrichtung des Gehäusehauptteils (10) sich zumindest teilweise nicht mit einer senkrechten Projektion der zweiten dreidimensionalen Textur (24) in der Dickenrichtung des Gehäusehauptteils (10) überlappt.

11. Gehäuse für ein elektronisches Gerät nach einem der Ansprüche 1 bis 10, wobei eine maximale Dicke des Gehäusehauptteils (10) in einem Bereich von 3 mm bis 10 mm liegt und eine minimale Dicke des Gehäusehauptteils (10) größer als oder gleich 0,4 mm ist.

12. Verfahren zum Herstellen eines Gehäuses für ein elektronisches Gerät, Folgendes umfassend:
Durchführen eines Formungsprozesses an einem Substrat, um einen Gehäusehauptteil (10) zu erhalten, wobei der Gehäusehauptteil (10) eine erste Wand (12) und mindestens eine zweite Wand (14) umfasst, die mit der ersten Wand (12) verbunden ist, wobei die erste Wand (12) eine Innenfläche (121) und eine Außenfläche (122) gegenüber der Innenfläche (121) aufweist, wobei die zweite Wand (14) eine Innenfläche (141) und eine Außenfläche (142) gegenüber der Innenfläche (141) der zweiten Wand (14) aufweist, wobei die Innenfläche (121) der ersten Wand (12) und die Innenfläche (141) der mindestens einen zweiten Wand (14) zusammenwirkend einen Unterbringungsraum definieren, und die Außenfläche (122) der ersten Wand (12) eben oder gekrümmt ist, die Außenfläche (142) der zweiten Wand (14) gekrümmt ist und mindestens ein Teil von mindestens einer der Außenflächen und der Innenflächen der ersten Wand (12) und der zweiten Wand (14) mit einer dreidimensionalen Textur im Millimeterbereich angeordnet ist,
wobei die dreidimensionale Textur (20) im Millimeterbereich eine erste dreidimensionale Textur (22) und eine zweite dreidimensionale Textur (24) umfasst,
mindestens eine von der Innenfläche (121) der ersten Wand (12) und der Innenfläche (141) der zweiten Wand (14) mit der ersten dreidimensionalen Textur (22) angeordnet ist und mindestens eine von der Außenfläche (122) der ersten Wand (12) und der Außenfläche (142) der zweiten Wand (14) mit der zweiten dreidimensionalen Textur (24) angeordnet ist, und
die erste dreidimensionale Textur (22) und die zweite dreidimensionale Textur (24) jeweils mehrere texturierte Flächen umfassen, wobei die mehreren texturierten Flächen Flächen umfassen, die sich in unterschiedliche Richtungen erstrecken,
ein erster R-Winkel an einem Schnittpunkt von zwei der mehreren texturierten Flächen gebildet ist und einen ersten Radius in einem Bereich von 0,2 bis 1 mm aufweist,
ein zweiter Winkel an einem Schnittpunkt zwischen der ersten dreidimensionalen Textur (22) und einer Referenzfläche der Innenfläche des Gehäusehauptteils (10) gebildet ist und einen zweiten Radius aufweist und der Radius größer als oder gleich 0,5 mm ist.

13. Elektronisches Gerät, Folgendes umfassend:
das Gehäuse für ein elektronisches Gerät nach einem der Ansprüche 1 bis 11 und
eine Anzeige (200), die in dem Unterbringungsraum des elektronischen Geräts aufgenommen ist.

## Revendications

1. Boîtier pour dispositif électronique, comprenant :
un corps (10) de boîtier, comprenant une première paroi (12) et au moins une deuxième paroi (14) reliée à la première paroi (12), la première paroi (12) présentant une surface interne (121) et une surface externe (122) opposée à la surface interne (121), la deuxième paroi (14) présentant une surface interne (141) et une surface externe (142) opposée à la surface interne (141) de la deuxième paroi (14), la surface interne (121) de la première paroi (12) et la surface interne (141) de l'au moins une deuxième paroi (14) coopérant pour définir un espace d'accueil, la surface externe (122) de la première paroi (12) étant plane ou courbe, la surface externe (142) de l'au moins une deuxième paroi (14) étant courbe, et au moins une partie des surfaces externes (122, 142) et/ou des surfaces internes (121, 141) de la première paroi (12) et de la deuxième paroi (14) étant pourvue d'une texture tridimensionnelle à l'échelle millimétrique (20) ;
dans lequel la texture tridimensionnelle à l'échelle millimétrique (20) comprend une première texture tridimensionnelle (22) et une deuxième texture tridimensionnelle (24),
la surface interne (121) de la première paroi (12) et/ou la surface interne (141) de la deuxième paroi (14) sont pourvues de la première texture tridimensionnelle (22), et la surface externe (122) de la première paroi (12) et la surface externe (142) de la deuxième paroi (14) sont pourvues de la deuxième texture tridimensionnelle (24) ; et
la première texture tridimensionnelle (22) et la deuxième texture tridimensionnelle (24) comprennent chacune une pluralité de surfaces texturées, la pluralité de surfaces texturées comprennent des surfaces s'étendant dans des directions différentes ;
un premier angle R est formé à une intersection entre deux de la pluralité de surfaces texturées et présente un premier rayon compris entre 0,2 et 1 mm ;
un deuxième angle est formé à une intersection entre la première texture tridimensionnelle (22) et une surface de référence de la surface interne du corps (10) de boîtier et présente un deuxième rayon, et le deuxième rayon est supérieur ou égal à 0,5 mm.

2. Boîtier pour dispositif électronique selon la revendication 1, dans lequel le premier rayon est compris entre 0,8 mm et 1 mm.

3. Boîtier pour dispositif électronique selon l'une quelconque des revendications 1 à 2, dans lequel un autre angle est formé à une intersection entre la deuxième texture tridimensionnelle (24) et une surface de référence de la surface externe du corps (10) de boîtier et présente un troisième rayon, et le troisième rayon est supérieur ou égal à 0,5 mm, de préférence compris entre 0,8 mm et 1 mm.

4. Boîtier pour dispositif électronique selon l'une quelconque des revendications 1 à 3, dans lequel la première texture tridimensionnelle (22) est en creux vers un côté interne du corps (10) de boîtier, et la deuxième texture tridimensionnelle (24) est en relief vers un côté externe du corps (10) de boîtier.

5. Boîtier pour dispositif électronique selon l'une quelconque des revendications 1 à 4, dans lequel la hauteur de la première texture tridimensionnelle (22) est inférieure à la hauteur de la deuxième texture tridimensionnelle (24) ;
la hauteur de la première texture tridimensionnelle (22) est comprise entre 0,1 mm et 1 mm ; et
la hauteur de la deuxième texture tridimensionnelle (24) est comprise entre 0,5 mm et 2,5 mm.

6. Boîtier pour dispositif électronique selon l'une quelconque des revendications 1 à 5, dans lequel la première texture tridimensionnelle (22) et la deuxième texture tridimensionnelle (24) présentent chacune une largeur de ligne supérieure ou égale à 0,5 mm, de préférence supérieure ou égale à 1 mm, de préférence encore comprise entre 1 mm et 2 mm.

7. Boîtier pour dispositif électronique selon l'une quelconque des revendications 1 à 6, dans lequel
la première texture tridimensionnelle (22) comprend une pluralité de premières sous-textures espacées entre elles, une distance entre deux premières sous-textures adjacentes étant supérieure ou égale à 0,5 mm, de préférence supérieure ou égale à 1 mm ; et
la deuxième texture tridimensionnelle (24) comprend une pluralité de deuxièmes sous-textures espacées entre elles, une distance entre deux deuxièmes sous-textures adjacentes étant supérieure ou égale à 0,5 mm, de préférence supérieure ou égale à 1 mm.

8. Boîtier pour dispositif électronique selon l'une quelconque des revendications 1 à 7, dans lequel
un rapport entre une largeur de la première sous-texture et une distance entre deux premières sous-textures adjacentes est inférieur ou égal à 1:1, de préférence compris entre 1:1 et 1:8, de préférence encore compris entre 1:1 et 1:5 ; et
un rapport entre une largeur de la deuxième sous-texture et une distance entre deux deuxièmes sous-textures adjacentes est inférieur ou égal à 1:1, de préférence compris entre 1:1 et 1:8, de préférence encore compris entre 1:1 et 1:5.

9. Boîtier pour dispositif électronique selon l'une quelconque des revendications 1 à 8, dans lequel la première texture tridimensionnelle (22) et la deuxième texture tridimensionnelle (24) comprennent chacune des bandes linéaires et/ou des bandes courbes et/ou des motifs géométriques et/ou des motifs de forme irrégulière.

10. Boîtier pour dispositif électronique selon l'une quelconque des revendications 1 à 9, dans lequel une projection orthographique de la première texture tridimensionnelle (22) dans une direction d'épaisseur du corps (10) de boîtier ne se superpose pas au moins partiellement à une projection orthographique de la deuxième texture tridimensionnelle (24) dans la direction d'épaisseur du corps (10) de boîtier.

11. Boîtier pour dispositif électronique selon l'une quelconque des revendications 1 à 10, dans lequel une épaisseur maximale du corps (10) de boîtier est comprise entre 3 mm et 10 mm, et une épaisseur minimale du corps (10) de boîtier est supérieure ou égale à 0,4 mm.

12. Procédé de fabrication d'un boîtier pour dispositif électronique, comprenant :
la réalisation d'un procédé de moulage sur un substrat afin d'obtenir un corps (10) de boîtier, le corps (10) de boîtier comprenant une première paroi (12) et au moins une deuxième paroi (14) reliée à la première paroi (12),
la première paroi (12) présentant une surface interne (121) et une surface externe (122) opposée à la surface interne (121), la deuxième paroi (14) présentant une surface interne (141) et une surface externe (142) opposée à la surface interne (141) de la deuxième paroi (14), la surface interne (121) de la première paroi (12) et la surface interne (141) de l'au moins une deuxième paroi (14) coopérant pour définir un espace d'accueil ;
et la surface externe (122) de la première paroi (12) étant plane ou courbe, la surface externe (142) de l'au moins une deuxième paroi (14) étant courbe, et au moins une partie des surfaces externes et/ou des surfaces internes de la première paroi (12) et de la deuxième paroi (14) étant pourvue d'une texture tridimensionnelle à l'échelle millimétrique ;
dans lequel la texture tridimensionnelle à l'échelle millimétrique (20) comprend une première texture tridimensionnelle (22) et une deuxième texture tridimensionnelle (24) ;
la surface interne (121) de la première paroi (12) et/ou la surface interne (141) de la deuxième paroi (14) sont pourvues de la première texture tridimensionnelle (22), et la surface externe (122) de la première paroi (12) et/ou la surface externe (142) de la deuxième paroi (14) sont pourvues de la deuxième texture tridimensionnelle (24) ; et
la première texture tridimensionnelle (22) et la deuxième texture tridimensionnelle (24) comprennent chacune une pluralité de surfaces texturées, la pluralité de surfaces texturées comprennent des surfaces s'étendant dans des directions différentes ;
un premier angle R est formé à une intersection entre deux de la pluralité de surfaces texturées et présente un premier rayon compris entre 0,2 et 1 mm ;
un deuxième angle est formé à une intersection entre la première texture tridimensionnelle (22) et une surface de référence de la surface interne du corps (10) de boîtier et présente un deuxième rayon, et le rayon est supérieur ou égal à 0,5 mm.

13. Dispositif électronique, comprenant :
le boîtier pour dispositif électronique selon l'une quelconque des revendications 1 à 11 ; et
un affichage (200), reçu dans l'espace d'accueil du dispositif électronique.
